Europäisches Patentamt

European Patent Office

Office européen des brevets

(11) Publication number: **0 495 994 A1**

## EUROPEAN PATENT APPLICATION
### published in accordance with Art. 158(3) EPC

(21) Application number: 91913818.0

(22) Date of filing: **06.08.91**

(86) International application number: **PCT/JP91/01051**

(87) International publication number: **WO 92/02956 (20.02.92 92/05)**

(51) Int. Cl.5: **H01L 27/115**

(30) Priority: **07.08.90 JP 208941/90**

(43) Date of publication of application: **29.07.92 Bulletin 92/31**

(84) Designated Contracting States: **DE FR GB IT NL**

(71) Applicant: **SEIKO EPSON CORPORATION 4-1, Nishishinjuku 2-chome Shinjuku-ku Tokyo 163(JP)**

(72) Inventor: **FUJISAWA, Akira 3-5, Owa 3-chome Suwa-shi, Nagano-ken 392(JP)**

(74) Representative: **Bosotti, Luciano et al c/o Jacobacci-Casetta & Perani S.p.A. Via Alfieri, 17 I-10121 Torino(IT)**

(54) SEMICONDUCTOR DEVICE AND ITS MANUFACTURING METHOD.

(57) In a semiconductor device having a capacitive element whose substrate is a ferroelectric film. A ferroelectric film (103) is formed by a sputtering method and a ferroelectric film (104) is formed by a method of spin-coating of a solution. The thicknesses of the films are not extremely small at the edges of steps, and consequently the qualities of the films are good.

EP 0 495 994 A1

FIELD OF THE INVENTION

The present invention relates to a semiconductor memory element, more particularly to a process for forming a nonvolatile semiconductor device having a layer of ferroelectric material which has an electrically polarizable property as a basic layer.

BACKGROUND OF THE INVENTION

A memory device based on electrically polarizable layers has been developed since the early 1950's.

Information can be stored by applying voltage between oppositely arranged electrodes corresponding to upper and lower sides (in the case of a usual semiconductor device, according to the row and column address) thereby polarizing an area of an intersecting point of these electrodes. Further, a reading process can be carried out, for example, by piezoelectrically or pyroelectrically activating some particular memory areas or by effecting a destructive measure. In addition, the information can be held permanently due to the residual polarization of a ferroelectric material or substance, without being fed by an outer electric source. However, it has been found that circumferential devices, that is, electronic control devices or apparatus necessary for writing and reading the information are relatively complicated and require a considerably large access time. Accordingly, at the end of the 1970's it was proposed to integrate a ferroelectric memory element directly with a control module, or integrate them together (R, C. Kuck, United States Patent No.4,149,302 (1979)).

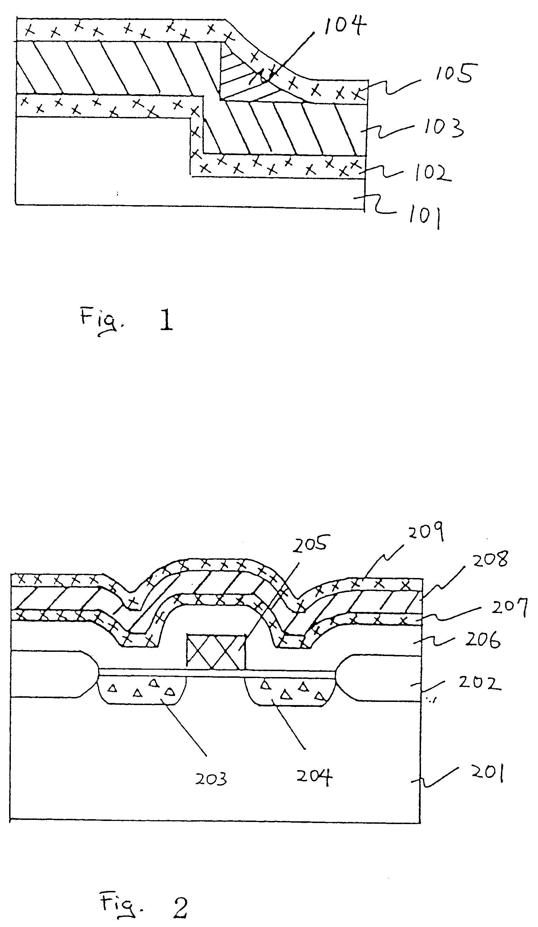

Recently, a memory device having a structure in which a ferroelectric memory and an element or elements are stacked over a MIS-type semiconductor device has been proposed, as shown in Fig. 2, in the IEDM '87 pp 850-857. In Fig. 2 the reference numeral 201 indicates a P-type silicon substrate, 202 a LOCOS oxide film for isolation, and 203 and 204 N-type diffusion layers, each of which becomes a source and drain region, respectively. The reference numeral 205 indicates a gate electrode and 206 is an interlayer insulation film. The reference numeral 208 indicates a ferroelectric film which is interposed between a lower electrode 207 and an upper electrode 209 to thereby form a capacitor.

In the conventional manufacturing process, the ferroelectric film shown by 208 is formed by a material of $PbTiO_3$, PZT or PLZT, and the film is formed on the lower electrode 207 by sputtering a target which is compensated by an excessive amount of lead in comparison with an appropriate amount of its stoichiometrical composition, or by spin coating a solution which comprises components for consisting the ferroelectric material. However, as shown in Fig. 2, a capacitor element is formed, through the interlayer insulation layer, on the MIS-type transistor which is formed on the silicon substrate. It is apparent that the interlayer insulation layer has its step portions caused by the gate electrode 205 and the LOCOS oxide film 202. It is well known matter that the electronic characteristic of the capacitor element strongly depends on the thickness of a dielectric material. Accordingly, it is one of important subjects to form a ferroelectric thin film having its good uniform thickness.

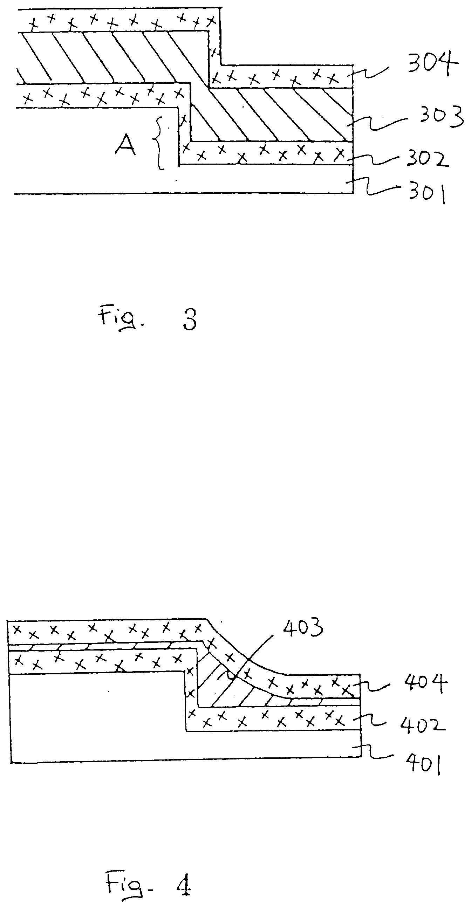

Fig. 3 is a sectional view showing a case where a ferroelectric thin film is formed on a step portion by means of a sputtering method.

In that case, when an interlayer insulation film 301 has a step portion, the thickness of only a portion of a ferroelectric thin film 303 on the step portion a becomes thin, which is caused by a thin film forming characteristic when using the sputtering method. At the thin thickness portion, an electric field strength is strong as compared with other portions, so that there remains a problem in reliability. In addition, the thickness of the whole film may be increased in order to make increase the film thickness at the step portion, but the polarization inversion characteristic lowers.

Fig. 4 is a sectional view showing a case where a ferroelectric thin film is formed on a step portion by using the spin coating method.

In that case, when an interlayer insulation film 401 has a step portion, a solvent 403 for forming the ferroelectric thin film concentrates in a region on the step portion.

Taking account of the above-mentioned problems, it may be possible to limit a capacitor element forming area to an area on a planer or flat portion on a MOS-type transistor, for example, on the LOCOS oxide film. However, in that case, the high integration of the device is restricted, so that it is difficult to get a fine structure of a memory device.

Then, a subject of the present invention is to provide a semiconductor device having formed therein a capacitor element or capacitor elements which has provided therein as a basic layer a ferroelectric layer of the high yield, high quality and high reliability by forming, even though a step portion is, or step portions are, provided, the layer as a ferroelectric thin layer with a good uniform thickness, and is to provide a process for manufacturing the semiconductor device.

DISCLOSURE OF THE INVENTION

In accordance with a process for manufacturing a semiconductor device of the present invention in which at least one capacitor element having a ferroelectric layer as a basic layer, in carrying out the formation of a thin layer directed to the ferroelectric layer on a semiconductor substrate, is characterized in comprising the following steps of:

forming the ferroelectric thin layer by using a sputtering technique; and

forming components for forming the ferroelectricity by using a spin coating technique thereby obtaining the ferroelectric thin film having a uniform thickness even though there is at least one step portion.

## BRIEF DESCRIPTION OF THE DRAWINGS

Fig. 1 is a main sectional view of the capacitor element at a step portion of a semiconductor memory device in which a basic layer is an electrically polarizable ferroelectric layer.

Fig. 2 is a main sectional view of a semiconductor memory device in which a basic layer is an electrically polarizable ferroelectric layer.

Fig. 3 is a sectional view showing a case where a ferroelectric thin film is formed on a step portion by using a sputtering technique.

Fig. 4 is a sectional view showing a case where a ferroelectric thin film is formed on a step portion by using a spin coating technique.

## BEST MODE FOR CARRYING OUT OF THE INVENTION

Hereinafter, the present invention is described in detail with reference to the accompanying drawings and concrete embodiments.

Fig. 1 is a main sectional view of a capacitor element at a step portion of a semiconductor device according to the present invention, the preferable embodiment of which will be explained according to the sequential steps.

First, an interlayer insulation film 101 is formed after carrying out a process for forming a usual CMOS. As the interlayer insulation film, silicon oxide is formed to a thickness of 5000 Å by using, for example, a CVD method. Next, a lower electrode 102 is formed to a thickness of 1000 Å by using, for example, a sputtering method. Then, a thin film 103 intended to form a ferroelectric layer, which relates to the present invention, is formed, for example, by sputtering to a thickness of 1000 Å.

Thereafter, a solvent having components for forming the ferroelectricity is dropped by an amount of 2 - 3 ml on the substrate which is rotating at a speed of 2000 - 6000 round/minute to thereby perform the coating treatment. The solvent 104 is formed so as to compensate or complement the coverage at a step portion of the thin film formed by the sputtering method by using the characteristic appearing when a thin film is formed by the spin coating method. Then, the substrate is dried in an atmosphere of a temperature from 60 degrees to 80 degrees to thereby cause the volatilization of the solvent medium from the solvent. Next, the thin film 103 and 104 intended to form the ferroelectric layer are subjected to a heat treatment to thereby perform the crystallization of the thin films. The heat treatment is carried out, for example, in an atmosphere of oxygen at a temperature of 600°C during one hour.

Then, a material such as, for example, platinum, aluminum or molybdenum which will form an upper electrode 105, is formed, for example, by a sputtering method to a thickness of 3000 Å.

Thereafter, any suitable patterning step is, or steps are, carried out by using a photolithography technique thereby forming a device.

In the present embodiment, after forming the thin film which is intended to form the ferroelectric film by using the sputtering method, but it is needless to say that there are no problems even if the sequence of the above treatments is changed to another sequence.

## INDUSTRIAL AVAILABILITY

As described above, according to the present invention, since it is possible to form a thin film intended to form a ferroelectric layer to a uniform thickness without depending DOBOGRAPHY of a surface on which the thin film is formed, it becomes possible to produce a semiconductor device in which at least one capacitor element having as a basic layer a ferroelectric layer of a high yield, high quality and high reliability, while keeping a high integration density and a fine structure.

## Claims

1. A semiconductor device which is characterized in that a thin film intended to form a ferroelectric layer of the semiconductor device which has formed therein a capacitor element having the ferroelectric layer as a basic layer, comprises at least:

a thin film formed by a sputtering method, and

a thin film formed by a spin coating of a solution which includes components for forming a ferroelectricity.

2. A process for forming a thin film intended to form a ferroelectric layer on a semiconductor device substrate of a semiconductor device which has formed therein a capacitor element having the ferroelectric layer as a basic layer, which is characterized in comprising the following steps of:

forming the thin film intended to form the ferroelectric layer by a sputtering method, and

forming a thin film by a spin coating of a solution which includes components for forming the ferroelectricity.

Fig. 1

Fig. 2

Fig. 3

Fig. 4

# INTERNATIONAL SEARCH REPORT

International Application No PCT/JP91/01051

## I. CLASSIFICATION OF SUBJECT MATTER (if several classification symbols apply, indicate all) 6

According to International Patent Classification (IPC) or to both National Classification and IPC

Int. Cl$^5$ H01L27/115

## II. FIELDS SEARCHED

| Minimum Documentation Searched 7 | |
|---|---|
| Classification System | Classification Symbols |
| IPC | H01L27/115, 29/792, 21/3205 |

| Documentation Searched other than Minimum Documentation to the Extent that such Documents are Included in the Fields Searched 8 | |
|---|---|
| Jitsuyo Shinan Koho | 1970 - 1990 |
| Kokai Jitsuyo Shinan Koho | 1972 - 1990 |

## III. DOCUMENTS CONSIDERED TO BE RELEVANT 9

| Category * | Citation of Document, 11 with indication, where appropriate, of the relevant passages 12 | Relevant to Claim No. 13 |
|---|---|---|
| Y | JP, A, 2-183570 (Seiko Epson Corp.), July 18, 1990 (18. 07. 90), Line 10, upper right column to line 3, lower left column, page 2 | 1, 2 |
| Y | JP, A, 2-186669 (Seiko Epson Corp.), July 20, 1990 (20. 07. 90) | 1, 2 |
| Y | JP, A, 61-228655 (NEC Corp.), October 11, 1986 (11. 10. 86), (Family: none) | 1, 2 |

* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| October 28, 1991 (28. 10. 91) | November 5, 1991 (05. 11. 91) |
| International Searching Authority | Signature of Authorized Officer |
| Japanese Patent Office | |

Form PCT/ISA/210 (second sheet) (January 1985)